# EUROPEAN PATENT APPLICATION

(11) **EP 0 786 806 A1**
(43) Date of publication of application: **30.07.1997**
(21) Application number: 96480005.6
(22) Date of filing: 23.01.1996
(51) Int. Cl.: H01L 23/433

(54) **High I/O density package for high power wire-bonded IC chips and method for making the same**

(71) Applicant: MONTPELLIER TECHNOLOGIES, 34055 Montpellier Cédex 1 (FR)
(72) Inventor: Cooppens, Pierre, F-34820 Assas (FR); Morazzani, Marc, F-34090 Montpellier (FR); Escude, Jean-Jacques, F-34820 Assas (FR)
(74) Representative: Klein, Daniel Jacques Henri

(57) **Abstract**

According to the present invention, there are described a novel cavity-up package (30) having efficient heat dissipation capabilities well adapted to high power wire-bonded IC chips (33) and a method for making the same. The IC chip (33) is mounted in a cavity (32) of a cavity-up substrate (31) with its active surface turned upside. The fragile bonding wires (35) which interconnect the contact pads (36) at the periphery of the IC chip and metal lands of the substrate are encapsulated at contact pad locations with a protective material. There is formed a ring-shaped stiffener (38) that delineates a recess (39) substantially exposing the whole IC chip active surface (where heat is produced). Then, the recess is filled with an adequate quantity of thermal grease to form a layer (40). Finally, a cap (41) having a mesa-shaped pedestal (42) fitting with said recess is firmly affixed onto the substrate so that the pedestal squeezes the grease down to the desired thickness for excellent heat transfer between the IC chip active surface and the cap. Optionally, a heat sink (43) can be bonded to the cap to still improve heat dissipation. The cavity-up package fabricated according to this method keeps all the inherent advantages (high number of I/O's, small footprint) of the cavity-up packaging technique without its inconveniences (low heat dissipation). In particular, it offers a very efficient heat dissipation scheme to high power wire-bonded semiconductor IC chips without damaging the fragile bonding wires. The method is also applicable to flat packages as well and moreover can be extended to MCM packages.

## Description

### FIELD OF INVENTION

The present invention relates to packaging techniques for high power wire-bonded semiconductor integrated circuit chips and more particularly to a high I/O density package in which a cap (and/or a heat sink) is efficiently coupled to the active surface of the chip for improved heat dissipation without damaging the fragile bonding wires.

### BACKGROUND OF THE INVENTION

In many cases, modern semiconductor integrated circuit (IC) chips are designed to handle large amounts of power. In particular, because there is a standing requirement to integrate a maximum of electrical circuits in a semiconductor substrate to reach the highest possible level of device integration, an effective heat dissipation is a major concern to date. This in turn has led to the mandatory use of heat dissipaters generally known as heat sinks. Prior art techniques related to heat dissipation for high power wire-bonded semiconductor chips have followed a variety of paths to provide solutions adapted to efficiently evacuate heat out of packages that are inclined to become smaller and denser.

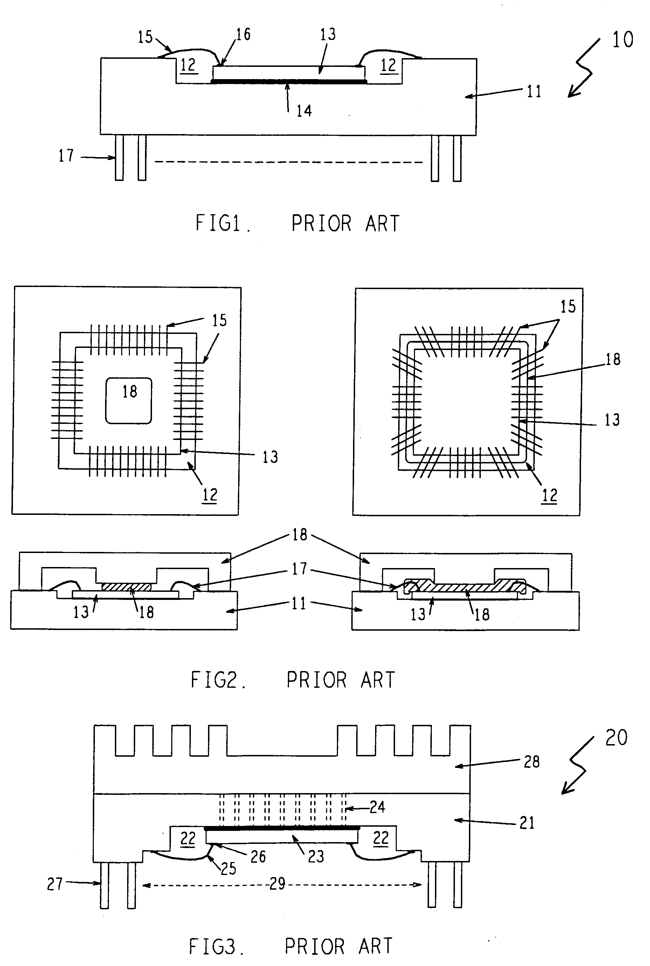

Traditionally, according to a first conventional approach high power wire-bonded IC chips have been packaged in cavity-up substrates. A cross section of a conventional cavity-up package is shown in Fig. 1 where it is indicated by reference numeral 10. A cavity-up (upward facing) substrate 11 is provided with a cavity 12 at its top side in which an IC chip 13 is attached by means of a layer 14 thermally conductive material (glue or eutectic solder). Bonding wires 15 make an electrical connection between the IC chip contact pads 16 and metal lands (not shown) formed at the surface of the substrate as standard. In turn, these metal lands are connected to input/output (I/O) terminals, typically solder balls/columns or pins 17, for external connections with conductors carried by a printed circuit board.

The major problem with the cavity-up package 10 of Fig. 1 (or any type of non-cavity package) is that it is severely limited in its heat dissipating capabilities. In this case, the active surface of the IC chip (where heat is produced) is connected to air which is a poor thermal conductor. As a result, for a high power wire-bonded IC chip, a heat sink is absolutely necessary. Without it, heat transfer would be very poor causing thereby irreparable damage to the IC chip. Obviously, it is not possible to attach a heat sink to the substrate backside because of the presence of I/O's 17. On the other hand, it is very difficult to apply a heat sink directly onto the active surface of the IC chip for heat evacuation mainly because of the presence of fragile bonding wires. All attempts rely on the use of a thermal compound, such as a thermal grease, dispensed between the heat sink and the IC chip active surface, as it will now be illustrated by reference to Fig. 2, which focuses on the central portion of cavity-up package 10 of Fig. 1. An adequate material is Amicon S 4500 sold by GRACE, Westerlo, Belgium. When dispensing the grease on top of a high power wire-bonded IC chip the objective is twofold: the area of the active face covered by the grease layer has to be maximum (to reduce the ther mal resistance Rth) and the thickness of the grease layer between the said surface and the heat sink has to be minimum (to further reduce Rth). In addition, care must be exercised when the heat sink is applied onto the grease layer for spreading it to avoid any stress that could break the very fragile bonding wires (whose diameter is typically in the 20-30 µm range) at the chip periphery, especially in IC chip corners as the force is radial. Those skilled in the art know that thermal greases are extraordinary viscous materials. There are two classical ways to obviate these drawbacks. According to the first one, a limited amount of grease is deposited to form layer 18 as illustrated in Fig. 2 (A). The grease layer 18 is slightly flattened by the heat sink 19 which is gently pressed thereon. Obviously, this technique leads to an incomplete and non homogeneous heat transfer because the IC chip active surface is only partially coated with the grease and moreover, its implementation in a manufacturing environment is obviously difficult. According to the second one illustrated in Fig. 2(B), it is mandatory to have the spanning of bonding wires 17 arranged so that all wires are disposed radially. As a consequence, the grease layer 18 spreads and flows in a longitudinal way thereby reducing stresses while coating the totality of the IC chip active surface. The thermal transfer between the IC chip 13 active surface and heat sink 19 is increased, but there still remains a non negligible risk of breaking the wires. In addition, a radial spanning is not always achievable because the chip pad arrangement is defined by the IC chip manufacturer and the top substrate padding has to fit different constraints (e.g. module design ground rules). Therefore, as illustrated in Fig. 2, there has been no satisfactory solution known to date to thermally couple a cap or a heat sink to the active surface of a high power wire-bonded IC chip.

The second classical approach to cool a high power wire-bonded IC chip is to use a cavity-down package, as it will be now described by reference to Fig. 3. Because the IC chip attachment to the substrate is a major element of the heat dissipation phenomenon, the passive surface of the chip is turned upside and is attached to the substrate at the bottom of the cavity thus allowing propagation of heat thru the bulk of the substrate to the heat sink. The IC chip active surface (where heat is produced) is still thermally connected to the air. Such a package is shown in Fig. 3 where similar elements bear corresponding reference numerals with respect to the package 10 of Fig. 1. Now turning to Fig. 3, there is shown a package referenced 20 comprised of downwards facing substrate 21 provided with a cavity 22 formed into its backside with IC chip 23 attached thereto by a thermally conductive layer 24 as explained above. As apparent from Fig. 3, the IC chip 23 is now upside-down. Bonding wires 25 interconnect the IC chip contact pads 26 to metal lands formed at the backside for transferring electrical signals to the I/O's 27. The heat sink 28 is attached to the top side of the substrate opposite to the cavity 22. This solution which allows an easy attachment of the heat sink 28 to the top side of substrate 21 has still some major inconveniences. Firstly, it is not possible to place any I/O's (balls/columns or pins) in all the central area referenced 29 on the backside of the substrate. This area which largely extends beyond the IC chip 23 surface results in a depopulated zone free of I/O's which is detrimental to the connection density for this type of package. In addition, for a same IC chip requiring an equal number of I/O's, the size of substrate 21 of Fig. 2 must be much larger than the size of the substrate 11 of Fig. 1 (as apparent from a comparison between the two drawings) to overcome the limitation caused by depopulated zone 29. In addition, because thermal transmission is less effective through the passive surface of the IC chip than by its active surface, the heat sink 28 must have larger dimensions that also favors an over-dimensioned substrate 21 footprint. The package footprint is the area occupied by the package on the printed circuit board which should be kept as small as possible so that more packages can be placed on the board. Finally, it must also be made of an adequate material still for thermal resistance (Rth) reduction. For instance, if the substrate 21 is made of a ceramic material (good Rth), the heat sink 28 can be attached directly to the top side of the substrate 21. However, if the substrate 21 is made of an organic material (poor Rth), buried thermal vias (shown in dotted lines in Fig. 3) are required to conduct the heat between the IC chip passive surface and the heat sink 28.

Consequently, there still remains a demand for a solution combining the advantages of cavity-up or non-cavity (flat) packages without their inconveniences. A solution that would be based upon a cavity-up or a flat (also referred to as a non-cavity) package i.e. workable for a great number of I/O's and having a small footprint but with a more efficient heat dissipation scheme. It would be thus highly desirable to coat the totality of the IC chip active surface (where heat is produced) and to apply a cap (and/or a heat sink) thereon without damaging the fragile bonding wires or requiring a special spanning of the bonding wires.

### OBJECTS OF THE PRESENT INVENTION

It is therefore a primary object of the present invention to provide a cavity-up (or flat) package adapted to high power wire-bonded IC chips that keeps all the advantages (high I/O density and small footprint) inherent to that technique but with a more efficient heat dissipation scheme.

It is another object of the present invention to provide a cavity-up (or flat) package adapted to high power wire-bonded IC chips wherein substantially all the IC chip active surface is coated with a thermal grease and a cap (and/or a heat sink) is applied thereon without damaging the fragile bonding wires.

It is another object of the present invention to provide a cavity-up (or flat) package adapted to high power wire-bonded IC chips wherein a thermal grease if deposited over substantially all the IC chip active surface without requiring a special spanning of the bonding wires.

It is another object of the present invention to provide a cavity-up (or flat) package adapted to high power wire-bonded IC chips wherein a ring-shaped stiffener is formed at the periphery of the IC chip to encapsulate the bonding wires at contact pad locations to protect them.

It is still another object of the present invention to provide a cavity-up (or flat) package adapted to high power wire-bonded IC chips wherein the cap (and/or the heat sink) is provided with a mesa-shaped pedestal that fits with the ring-shaped stiffener interior space to squeeze the grease at the desired thickness.

It is still another further object of the present invention to provide a method of making a cavity-up (or flat) package adapted to high power wire-bonded IC chips that has excellent heat dissipation capabilities.

### SUMMARY OF THE PRESENT INVENTION

According to the present invention, there are described a novel cavity-up (or flat) package having efficient heat dissipation capabilities adapted to high power wire-bonded IC chips and a method for making the same. The IC chip is upwardly mounted onto the substrate surface. The fragile bonding wires which interconnect the contact pads at the periphery of the IC chip and metal lands of the substrate are encapsulated in a material at contact pad locations. As a result, there is formed a ring-shaped stiffener which protects the bonding wire extremities for the subsequent steps. In addition, the stiffener forms a dam-like structure which delineates a recess substantially exposing the whole active surface (where heat is produced) of the IC chip. Next, the recess is filled with an adequate quantity of a thermal compound such as a thermal grease. Finally, a cap (or a heat sink) is coupled to the IC chip active surface. It is provided with a mesa-shaped pedestal at its backside which fits well with said recess. It is firmly affixed onto the substrate so that the pedestal presses the grease down to the desired thickness for excellent heat transfer between the IC chip active surface and the cap. The cap is applied onto the substrate without damaging the fragile bonding wires thanks to the protection offered by the stiffener. The package fabricated according to this method keeps the inherent advantages of the so- called "cavity-up" or "flat" packaging techniques (high number of I/O's, small footprint) without its inherent inconveniences (low heat dissipation). It offers a very efficient heat dissipation scheme well adapted to any type of high power wire-bonded semiconductor IC chips (standard or radial wire spanning) without the risk of damaging said fragile bonding wires. It is also perfectly adapted to Multi-Chip-Module (MCM) technology.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

Fig. 1 is a schematic cut-away side view of a typical cavity-up package of the prior art including a high power wire-bonded IC chip attached to the cavity bottom.

Fig. 2 shows a top view of the package of Fig. 1 when a heat sink is applied onto the active surface of the IC chip with an intermediate thermal grease layer for better heat evacuation, either with a small quantity of grease in case of a standard wire spanning (A) or with a greater quantity of grease in case of a radial wire spanning (B).

Fig. 3 is a schematic cut-away side view of a typical cavity-down package of the prior art still including a high power wire-bonded IC chip attached to the cavity bottom.

Fig. 4 illustrates the step sequence of the method of fabricating the cavity-up package with improved heat dis sipation capabilities in accordance with the present in vention.

### DESCRIPTION OF A PREFERRED EMBODIMENT

The following proposal solves all above mentioned problems described by reference to Figs. 1 to 3 of the prior art solutions, The novel method is industrially oriented to wards high process yields and provides a high I/O density package with a very efficient heat dissipation scheme well adapted to high power wire-bonded IC chips. The basic idea is to encapsulate the extremities of bonding wires at contact pad locations with a stiffening material. After hardening, there is formed a ring-shaped stiffener at the periphery of the IC chip which (i) protects said extremities and (ii) delineates a recess in its interior space substantially exposing all the IC chip active surface. Then, a thermal compound, such as a thermal grease, is dispensed in the recess in a very simple manner. Finally, a cap having an interior shape that fits well with the recess is applied pressing the excess grease to flow. This method which will be described by reference to a cavity-up substrate is also applicable to flat (non-cavity) substrates.

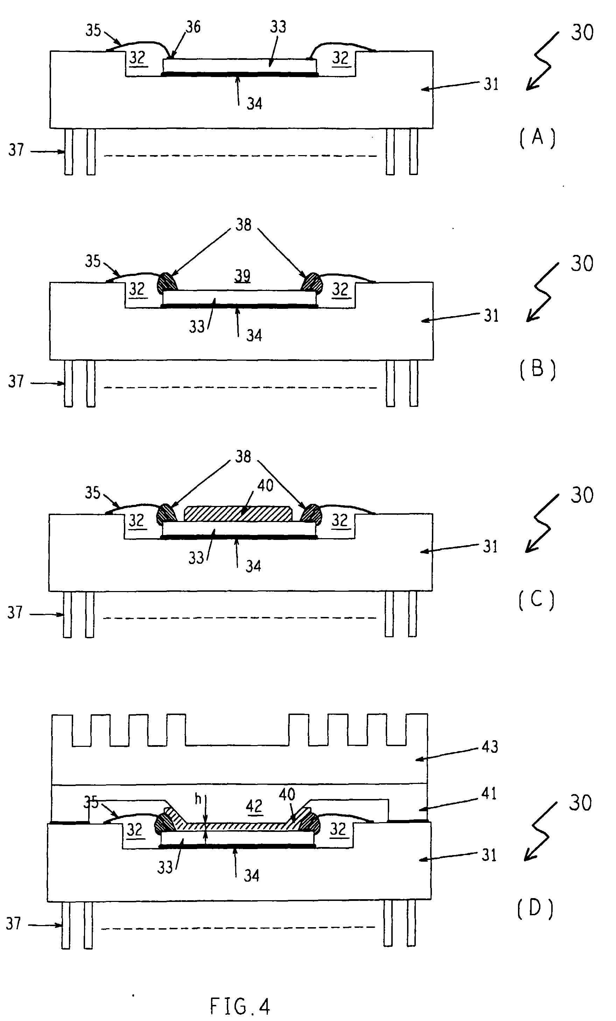

The process is standard until the wire bonding step which results in the conventional package referenced 30 in Fig. 4A. Likewise, similar elements with respect to package 10 of Fig.1 and package 20 of Fig. 2 bear corresponding reference numerals. The novel sequence of operating steps reads as follows.

### Stiffening material dispensing step

A stiffening material is dispensed using a conventional system such as manufactured by SCHILLER ROBOT, Sonnenbuhl-Genkingen, Germany, to encapsulate the extremities of the bonding wires 35 bonded to IC chip pads 36 and the contact pads themselves. As known for those skilled in the art, contact pads are situated at the periphery of wire-bonded IC chips. The stiffening material can eventually smear beyond the substrate sides without damage. The stiffening material could be similar to the materials used for glob top (glass filled epoxy). It should also be possible to use a thermal grease, but the latter should be less viscous than the ones used in the following step of grease dispensing not to damage the bonding wires. Adequate materials in all respects are ABLEBOND 84-3GTLTC sold by ABLESTIK, Rancho Dominguez, CA, USA or DYMAX 9000 sold by DYMAX Corp., Torrington, CT, USA. Next, a curing step (125 îC, 4 hours) is required to harden the stiffening material. The quantity to be dispensed is determined by the specific package in consideration. The objective is to build a ring-shaped stiffener 38 having a smooth profile that runs around the chip border and encapsulates all bonding wire extremities at contact pad locations for safe protection thereof. In addition, as apparent from Fig. 4B, the ring-shaped stiffener 38 acts like a dam or a coral reef to delineate a recess 39 that substantially exposes the whole IC chip 33 active surface. In Fig. 4B, neither the stiffener nor the recess are to scale, it should be understood that the ring-shaped stiffener 38 is relatively narrow when compared to the IC chip total active surface.

### Grease dispensing step

Then, a thermal grease (such as the above mentioned ma terial) is dispensed over the recess 39 in a quantity slightly larger than the volume necessary to coat all the IC chip 33 active surface. The exact quantity is determined after a few experiments conducted with the specific package in consideration so that after the cap is affixed, the grease layer 40 thickness in the recess bottom is adequate. At this stage of the process, the resulting package 30 is shown in Fig. 4C.

### Cap affixing step

Next, a cap 41 is firmly applied atop the package 30 by means of a sealing adhesive as standard. It is made of an inexpensive heat conducting material such as aluminum. Its internal shape is adapted to fit with recess 39 and for that purpose it is provided with a mesa-shaped pedestal referenced 42 in Fig. 4D. As apparent from Fig. 4D, the cap 41 is designed to provide a spacing s between the bottom face of the pedestal 42 and the IC chip 33 active surface. With this construction, when the cap 41 is applied onto the substrate 31, the grease layer 40 is squeezed down to a predetermined thickness equal to said spacing s. The optimum grease layer thickness appears to be in the 150-200 µm range. As illustrated in Fig. 4D, the grease does not spread too much over the bonding wires 35, however, it would not be detrimental to the present process if the grease of layer 40 smears and flows in the cavity 22.

Now the process continues as standard. However, a heat sink 43 can be bonded onto the cap 41 top side (if so required for further thermal enhancement). The resulting package at the final stage of the fabrication process is shown in Fig. 4D.

The novel method of coupling a cap of the present invention as described by reference to Fig. 4 (with or without a heat sink) results in a package 30 that has definite advantages over the previous packages 10 and 20 shown in Figs. 1 and 3 respectively.

This novel package 30 features all the inherent advantages of the cavity-up or flat packages, i.e. a large number of I/O's (solder balls/columns or pins) and minimum dimensions (footprint). In addition, due to its improved structure, it has further advantages including a very efficient heat dissipation scheme (grease layer having an optimum thickness and large area of heat transfer). Moreover, it is operable with any type of high power wire-bonded IC chip (standard or radial spanning) with high reliability (no risk of damaging the bonding wires).

A package has been fabricated according to the teachings of the present invention. It features 10 W power dissipation capability and with a 34 mm LTCC (Low Temperature Co-fired Ceramic) substrate, it accepts IC chips up to 15 mm and provides 676 I/O's in a BGA (Ball Grid Array) or CGA (Columns Grid Array) arrangement. The method of the present invention can also be extended to MCM packages.

The package of the present invention is an excellent response to requests recently made by users to develop a package adapted to wire bonded IC chips, mounted on small ceramic or organic substrates (e.g. 30 mm), offering a high number of I/O's (>300-400) and capable of high power dissipation (>10W).

## Claims

1. A package (30) for heat dissipation of a substantially flat high power wire-bonded electronic component having active and passive surfaces with a plurality of contact pads disposed at the periphery of the active surface comprising:
an electronic component (33) mounted onto a substrate (31) with its active surface turned upwards wherein bond ing wires (35) are bonded between said contact pads (36) and metal lands formed onto the substrate for electrical connections therebetween;
a ring-shaped stiffener (38) made of a material that encapsulates the extremities of said bonding wires at contact pad locations to protect them and to form a damlike structure that delineates a recess (39) which substantially exposes all the electronic component active surface;
a layer (40) of a thermal compound totally filling said recess; and,
a cap (41) firmly affixed onto the substrate having a mesa-shaped pedestal (42) fitting with said recess and spaced from the IC component active surface by a determined spacing (s) equal to the desired thermal compound layer thickness to ensure an excellent thermal transfer between the cap and said electronic component active sur- face.

2. The package of claim 1 further comprising:
a heat sink (43) bonded to the surface of said cap.

3. The package of claim 1 or 2 wherein said electronic component is a semiconductor integrated circuit chip.

4. The package of claim 1, 2 or 3 wherein said substrate is either flat (non-cavity) or of the cavity-up type.

5. A method for fabricating a package (30) adapted to the cooling of a high power wire-bonded electronic component (33) having active and passive surfaces with a plurality of contact pads disposed at the periphery of the active surface thereof comprising the steps of:
attaching said electronic component (33) to a substrate (31) with its active surface where heat is produced turned upwards;
bonding wires (35) between the contact pads of the electronic component and metal lands carried by the substrate;
dispensing a stiffening material to encapsulate the extremities of said bonding wires at said contact pad locations to protect them and to form a ring-shaped stiffener (38) that delineates a recess (39) which substantially exposes all the said component active surface;
dispensing a determined quantity of a thermal compound to create a layer (38) that at least partially fills said recess; and,
applying a cap (41) having a mesa-shaped pedestal (42) fitting said recess onto the resulting structure so that said pedestal squeezes the thermal compound for spreading it all over said component active surface down to the layer desired thickness without damaging said bonding wires that remain protected by the stiffening material.
